# EUROPEAN PATENT APPLICATION

(11) **EP 0 871 037 A1**
(43) Date of publication of application: **14.10.1998**
(21) Application number: 97105685.8
(22) Date of filing: 07.04.1997
(51) Int. Cl.: G01R 31/40

(54) **Circuit arrangement for monitoring an electronic circuit**

(71) Applicant: SIEMENS AKTIENGESELLSCHAFT, 80333 München (DE); STMicroelectronics S.r.l., 20041 Agrate Brianza (Milano) (IT)
(72) Inventor: Sass, Dieter, Dr., 93059 Regensburg (DE); Poletto, Vanni, Dr., I-Castello (IT)
(74) Representative: Epping, Wilhelm, Dr.-Ing.

(57) **Abstract**

The circuit arrangement monitors an electronic circuit using different monitoring means, which identify various faults in the power supply and emit a corresponding output signal which has different duty ratios depending on the fault identified. The different output signals are passed via a logic OR gate to a single detection line which is routed to a computing unit. The computing unit identifies the type of fault on the basis of the duty ratio of the output signal.

## Description

Electronic circuits are used, for example, for driving purposes or as a voltage source and provide evaluation means for monitoring the correct functioning of the electronic circuit, which evaluation means carry out diagnosis of the electronic circuit with regard to a short circuit or shunt and/or overcurrents.

DE 4030533 A1 discloses an arrangement for monitoring a load of an internal combustion engine in which the load is driven by an output stage in the form of a bridge circuit and the arrangement compares the potential in the region of the load or the output stage with predetermined threshold values which are derived from normal operation, and generates an alarm signal with a time delay from the comparison, the time delay depending on the magnitude of the drive signal.

The arrangement described has the disadvantage that it is not possible to identify the type of fault from the alarm signal.

The invention is based on the object of providing a circuit arrangement for monitoring an electronic circuit which emits output signals via a detection line, from which signals it is possible to identify the type of fault which occurs in the electronic circuit.

The object of the invention is achieved by means of the features of Claim 1.

It is particularly advantageous to ascertain faults which occur in an electronic circuit using monitoring means which emit an output signal which is characceristic of the fault identified and is forwarded by a switching device to a single detection line, with the result that it is possible to identify the type of fault in the electronic circuit on the basis of the nature of the output signal present on the detection line.

Further advantageous designs and improvements are specified in the subclaims.

The invention is explained in more detail with reference to the figures, in which
Figure 1 shows a circuit arrangement,
Figure 2 shows a bridge circuit,
Figure 3 shows a measurement signal and an output signal for monitoring for overcurrent,
Figure 4 shows a measurement signal and an output signal for monitoring for overtemperature, and
Figure 5 shows a measurement signal and an output signal for monitoring for an open line.

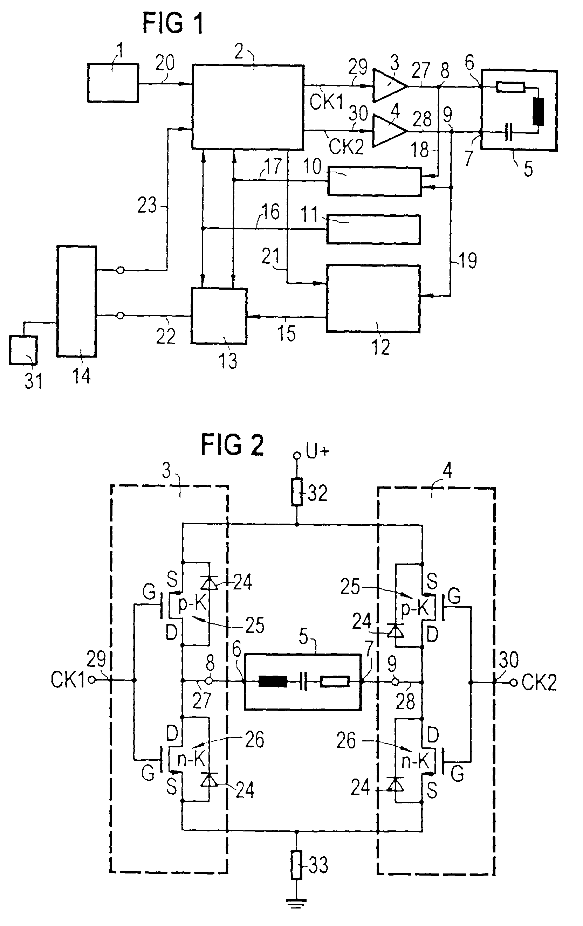

Figure 1 shows a current and voltage supply in the form of a first and a second drivable driver circuit 3, 4, which supply a load in the form of an antenna 5 with voltage via an input 6 and an output 7. The driver circuits are abbreviated below to drivers. The first driver 3 is connected via a first supply line 27 to the input 6 of the antenna 5. The second driver 4 is connected via a second supply line 28 to the output 7 of the antenna 5. The first and the second driver 3, 4 supply the antenna 5 at a predetermined transmission frequency for the transmission of signals.

A control unit 2 is connected via a first drive line 29 to the first driver 3 and via a second drive line 30 to the second driver 4. The control unit 2 controls the first driver 3 by means of a first control signal CK1 and the second driver 4 by means of a second control signal CK2, in such a way that the antenna 5 is supplied at a predetermined frequency and a predetermined voltage swing by the first and the second driver, which are designed as a bridge circuit 3, 4. The control unit 2 is connected via a clock line 20 to a clock generator 1, which supplies the control unit 2 with a system clock signal.

A first measuring point 8, from which a first measurement line 18 is routed to a first monitoring means 10 which is used for overcurrent identification, is provided on the first supply line 27.

A second measuring point 9, from which a second measurement line 19 is routed to the first monitoring means 10 and to the third monitoring means 12 which is used for checking a line break, is provided on the second supply line 28.

The first and the second driver 3, 4 constitute a bridge circuit which is preferably designed as an integrated circuit and serves to drive the antenna 5. A second monitoring means 11 which is thermally coupled to the first and second drivers 3, 4 and monitors the temperature of the first and of the second driver 3, 4 is arranged near the first and the second driver 3, 4.

The first monitoring means 10 compares the current flowing via the antenna 5 with stored reference values, which lie, for example, in the region of 0.7 A, and emits a first output signal via a first output line 17 when the current flow through the antenna 5 exceeds the predetermined reference values for a predetermined duration, in particular 32 µs. A switched-on transistor is provided, for example, for the purpose of current measurement, in the case of which transistor the voltage drop between the drain terminal and the source terminal is compared with a reference voltage.

The first output signal is fed via the first output line 17 to the control unit 2 and to a switching device 13. If the first monitoring means 10 now identifies a current flow which is above the reference value of 0.7 A, then the first monitoring means 10 changes the first output signal over from a high state to a low state. If the control unit 2 now identifies that the first output signal has been changed over from a high state to a low state, then the control unit 2 switches off the driving of the first and of the second driver 3, 4, with the result that the antenna 5 is no longer supplied with power.

The second monitoring means 11 measures the temperature in the region of the first and of the second driver 3, 4 and compares it with a stored reference value. The temperature measurement is effected, for example, by means of resistance measurement. If the measured temperature exceeds the predetermined reference value, then a corresponding, second output signal is emitted via a second output line 16. The second output signal is fed to the control unit 2 and to the switching device 13. If the control unit 2 receives the second output signal, then the control unit 2 interrupts the driving of the first and of the second driver 3, 4 until the second monitoring means 11 measures a temperature in the region of the first and of the second driver 3, 4 which is below a predetermined normal temperature, with the result that the second monitoring means 11 changes over the second output signal and the control unit 2 thereupon once again drives the first and the second driver 3, 4. The second monitoring means 11 preferably changes over the second output signal from a high state to a low state upon identification of a temperature lying above a predetermined maximum temperature. If the temperature falls below a predetermined minimum temperature, then the second monitoring unit 11 changes over the second output signal from the low state to a high state.

The third monitoring means 12 checks the current flow via the second supply line 28 in accordance with the same principle as the first monitoring means 10 and uses the comparison of the measured current value with a stored reference value to identify whether a line break exists. For this purpose, the third drive line 21 supplies the third monitoring means 12 with a signal from the control unit 2 which indicates the point in time at which the second driver 4 emits the maximum current. If the third monitoring means 12 then measures a current of less than 5 mA, for example, at this point in time, then the third monitoring means 12 identifies a line break.

When a line break is identified, the third monitoring means 12 emits a third output signal to the switching device 13. After identification of a line break, the third monitoring means 12 preferably changes over the third output signal, with a time delay, from a high state to a low state.

The switching device 13 is connected via a single detection line 22 to a computing unit 14, which is connected via an authorization line 23 to the control unit 2. The switching device 13 is preferably designed as a simple logic OR gate which switches through the first, the second or the third output signal onto the detection line 22. Consequently, the first and/or the second and/or the third output signal, which in each case constitute different signals, is fed to the computing unit 14 via the detection line 22. The computing unit 14 identifies a corresponding fault in the electronic circuit depending on the nature of the signal supplied.

The computing unit 14 stores a corresponding fault log in a memory 31 depending on the type of fault. Preferably, both a fault log is stored in the memory 31 and the control unit 2 is switched via the authorization line 23 into an off state, in which the control unit 2 no longer drives the first and the second driver 3, 4.

Figure 2 diagrammatically shows the bridge circuit constituted by the first and the second driver 3, 4. The first driver 3 has a p-channel transistor 25 which is arranged in parallel with an n-channel transistor 26, the gate terminals G of the p-channel transistor 25 and of the n-channel transistor 26 being connected to one another. In addition, the drain terminals D of the p-channel transistor 25 and of the n-channel transistor 26 are connected to one another. A diode 24 for current limiting is in each case connected between the source terminal S and the drain terminal D of the p-channel transistor 25 and between the source terminal S and the drain terminal D of the n-channel transistor 26. The gate terminals G of the n-channel transistor 26 and of the p-channel transistor 25 are connected to the first drive line 29 and, as a result, to the first drive signal CK1. The drain terminals D of the p-channel transistor 25 and of the n-channel transistor 26 are connected via the first supply line 27 to the input 6 of the antenna 5.

The second driver 4, which likewise has a p-channel transistor 25 and an n-channel transistor 26 is arranged in a mirror-symmetrical manner with respect to the first driver 3. The drain terminals D and the gate terminals G of the p-channel transistor 25 and of the n-channel transistor 26 are likewise connected to one another. The source terminals S of the p-channel transistor 25 and of the n-channel transistor 26 are in each case connected via a diode 24 to the corresponding drain terminal D of the p-channel transistor 25 and of the n-channel transistor 26 respectively. The second drive line 30 is connected to the gate terminals G. The drain terminals D are connected via the second supply line 28 to the output 7 of the antenna 5.

The source terminals of the p-channel transistors 25 of the first and of the second driver 3, 4 are connected to one another and are connected via a first resistor 32 to a voltage source U.

Equally, the source terminals of the n-channel transistor 26 of the first and of the second driver 3, 4 are connected to one another and are connected via a second resistor 33 to earth.

Figure 2 shows a bridge circuit 3, 4 with which the antenna 5 is supplied at a transmission frequency of 125 kHz by means of corresponding driving by the control unit 2. A maximum voltage swing is produced at the input 6 and at the output 7 of the antenna 5 by means of corresponding driving of the bridge circuit 3, 4. During the current measurement, the first and the second resistor 32, 33 serve for active current limiting, which lies above the overcurrent identification by the first monitoring means 10. Without current limiting, the current flow in the event of a short circuit might amount to a current intensity of a few amperes and lead to damage.

The bridge circuit is driven in a push-pull manner, that is to say the p-channel transistor of one driver 3, 4 and the n-channel transistor of the other driver 4, 3 are always switched on. The changeover must be carried out without any overlap, so that no parallel-path currents flow between the first and the second driver 3, 4.

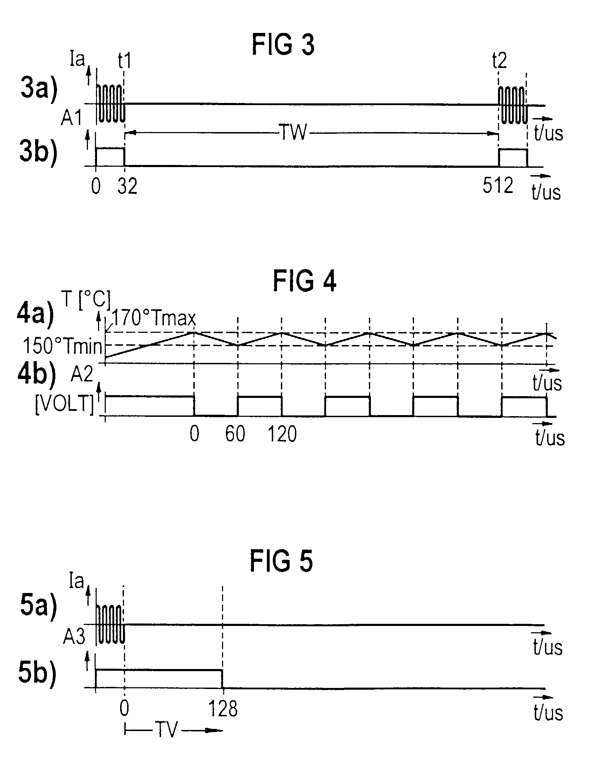

Figure 3 shows, in Figure 3a, the current Ia which is picked off by the first monitoring means 10 at the first measuring point 8 and corresponds to the current which flows through the antenna 5. The current Ia is plotted against the time t in µs in Figure 3a. If the current Ia exceeds a predetermined limit value for a predetermined duration, in particular 32 µs, then the first monitoring means 10 changes over the first output signal A1, which is plotted against the time t in Figure 3b, at the instant t1=32µs from a high state to a low state. The control unit 2 identifies the changeover of the first output signal to the low state and thereupon switches off the driving of the first and of the second driver 3, 4. Consequently, the current plotted in Figure 3a falls to the value 0 after the first and the second driver 3, 4 have been switched off.

After a predetermined waiting time TW, the first monitoring means 10 changes over the first output signal from the low state back to the high state, with the result that the control unit 2 once again drives the first and the second driver 3, 4 and the first monitoring means 10 measures a corresponding current flow. This corresponds to the instant t2 at 512 µs.

The first monitoring means 10 consequently checks the current flow through the antenna 5 and switches the first output signal to a low state again when the measured current is above the predetermined limit value. The current intensity is continuously checked in this way.

Figure 4 shows the method of functioning of the second monitoring means 11 for checking the temperature of the first and of the second driver 3, 4. In Figure 4a, the measured temperature T in degrees Celsius is plotted against the time t in µs. In Figure 4b, the second output signal A2 in volts is plotted against the time in µs. In order to assess the measured temperature, the second monitoring means 11 uses a maximum temperature tmax and a minimum temperature tmin. In this exemplary embodiment, the maximum temperature tmax is 170°C and the minimum temperature tmin is 150°C. If the measured temperature reaches the maximum temperature tmax, then the second output signal is switched from a high state to a low state. This is illustrated, for example, at the instant of t = 0 µs in Figure 4b.

After the changeover of the second output signal to a low state, the control unit 2 no longer drives the first and the second driver 3, 4, with the result that current no longer flows through the antenna 5. This is the case, for example, for the time in between 0 and 60 µs, as is illustrated in Figure 4b.

If the measured temperature now drops to the value of the minimum temperature tmin, then the second monitoring means 11 switches the second output signal from the low state back to the high state. This is the case at the instant of t = 60 µs.

The control unit 2 identifies the changeover of the second output signal to the high state and therefore once again drives the first and the second driver 3, 4, with the result that the antenna 5 is once again supplied with current. If the measured temperature now rises again to the maximum temperature tmax then the second monitoring means again changes over the second output signal to the low state. The second monitoring means 11 therefore ensures that the temperature of the first and of the second driver 3, 4 does not rise above a maximum value tmax and consequently prevents thermal damage to the first and to the second driver 3, 4. After being cooled to the minimum temperature tmin, the first and the second driver 3, 4 are switched on again by the control unit 2.

Preferably, the first and the second driver 3, 4 are designed as an integrated circuit and the second monitoring means 11 is constructed in addition to the first and the second driver 3, 4 as an integrated circuit on the same substrate, thereby effecting good thermal coupling between the first and the second driver 3, 4 and the second monitoring means 11.

Figure 5a shows the current Ia which flows through the antenna 5. As a function of the time t, in Figure 5b the third output signal A3 in volts is plotted against the time t and is provided for identification of an open line. The current Ia is measured at the second measuring point 9 of the second supply line 28. If, at the instant 0 µs at which the second driver 4 should deliver a maximum current, the third monitoring means 12 identifies that the current falls to the value 0 and remains at the value 0 for a predetermined monitoring time and is thus less than a reference value of, for example, 5 mA for the monitoring time, then the third monitoring means 12 identifies a line break after the monitoring time has elapsed, and changes over the third output signal from a high state to a low state.

In this exemplary embodiment, the monitoring time is preferably 128 µs, after which the third output signal is changed over to a low state.

If the third monitoring means 12 now once again identifies a current flow in the second supply line 28 which is above the reference value of 5 mA, then the third monitoring means 12 changes over the third output signal A3 from the low state to the high state.

The first, the second and the third output signal have, as illustrated in Figures 3b, 4b and 5b, different duty ratios when a fault occurs. The duty ratios for the various possible faults are stored in the memory 31, with the result that the computing unit 14 identifies a corresponding fault on the basis of the supplied duty ratio and correspondingly stores the type of fault in the fault log in the memory 31.

The first, the second and the third output signal are fed to the switching device 13, which in the simplest case constitutes a logic gate with an OR function, with the result that a signal having a low state is output on the detection line 22 whenever the first or the second or the third output signal has a low state.

## Claims

1. Circuit arrangement for monitoring an electronic circuit having means (10, 11, 12) for identifying different states of the electronic circuit, which means emit an output signal via output lines (17, 16, 15) after identification of a corresponding state, characterized in that the output lines (15, 16, 17) are routed to a switching unit (13) having a single outgoing detection line (22), in that the switching unit (13) forwards the output signals fed via the output lines (15, 16, 17) to the detection line (22), and in that the output signals of the means (10, 11, 12) differ from one another, with the result that the signal which is output on the detection line (22) permits conclusions concerning the state of the electronic circuit.

2. Circuit arrangement according to Claim 1, characterized in that the output signals which correspond to different states have different duty ratios between a high state and a low state of the output signal.

3. Circuit arrangement according to Claim 1, characterized in that the means (15, 16, 17) are designed to detect overcurrent and/or overtemperature and/or line break.

4. Circuit arrangement according to Claim 1, characterized in that the switching unit (13) constitutes a logic OR gate, which forwards a low signal onto the detection line (22) when a low signal is present on at least one output line (15, 16, 17).

5. Circuit arrangement according to Claim 1, characterized in that a computing unit (14) is connected to the detection line (22), in that the computing unit (14) is connected to a memory (31), in that the memory (31) assigns different faults of the electronic circuit to the various possible output signals, and in that the computing unit (14) assigns corresponding faults to the different signals which are fed via the detection line (22).

6. Circuit arrangement according to Claim 5, characterized in that the computing unit (14) stores in the memory (31) the fault which corresponds to the signal supplied.

7. Circuit arrangement according to Claim 1, characterized in that the electronic circuit constitutes a power supply for the transmitter of a remote control, in particular for a motor vehicle.
